# DEMANDE DE BREVET EUROPEEN

(11) **EP 1 843 277 A1**
(43) Date de publication de la demande: **10.10.2007**
(21) Numéro de dépôt: 06300325.5
(22) Date de dépôt: 04.04.2006
(51) Int. Cl.: G06K 19/07, G06K 7/00, G06F 13/00, G06K 19/077, H01L 21/60

(54) **Carte à puce USB**

(71) Demandeur: Axalto SA, 92120 Montrouge (FR)
(72) Inventeur: Leibenguth, Joseph, 92120 Montrouge (FR); Leroy, Pascal, 92120 Montrouge (FR); Khafif, Benali, 92120 Montrouge (FR); Roussel, François, 92120 Montrouge (FR)
(74) Mandataire: Cour, Pierre

(57) **Abrégé**

Une clef USB simplifiée 3 est réalisée en utilisant la technologie de fabrication d'une carte à puce 1. Les avantages de la carte à puce et de la clef USB sont alors réunis dans un seul produit. La carte à puce comporte un corps de carte 2 incluant une partie détachable 3 qui est munie d'une cavité 7 pour recevoir un module électronique 5 qui dispose de zones de contact électrique 52. La cavité 7 est pratiquée dans une zone de bordure de la partie détachable 3, ladite zone étant d'une largeur conforme au standard USB. Les zones de contact 52 sont conforment au standard USB. La partie détachable 3, une fois détachée, devient une clef USB enfichable dans un connecteur femelle USB de type A.

## Description

L'invention se rapporte à une carte à puce ayant une partie détachable qui se transforme en une clef USB enfichable dans un connecteur USB de type A

Les clefs USB sont des objets portables conformes à la norme USB et destinés à être enfichés dans un connecteur USB femelle. Les clefs USB sont notamment utilisées avec des ordinateurs disposant d'au moins un port USB. D'un point de vu fonctionnel, les clefs USB sont utilisées comme mémoire de masse amovible ou comme élément de sécurisation permettant de crypter/décrypter des fichiers ou des messages échangés sur un réseau ouvert. Une clef USB comporte généralement un connecteur mâle conforme à la norme USB, un circuit imprimé incluant des composants électroniques et un ou plusieurs circuit intégré permettant d'assurer la fonction désirée de la clef, le tout étant enfermé dans un boîtier enfermant les circuits. Les clefs USB sont des objets assez coûteux en raison du nombre d'éléments à assembler.

Parmi les objets portables conforme à la norme USB, il existe des cartes à puce selon la norme 7816 qui disposent d'une interface de communication de type USB. Ce type de carte est aussi décrit dans EP-A-1 110 173. Principalement, ce type de carte est réalisé avec un unique circuit intégré qui inclut un microprocesseur et une mémoire. De telles cartes sont destinées à des usages polyvalents utilisant des lecteurs ISO 7816 et des lecteurs USB. A titre d'exemple, dans le domaine de l'accès, une telle carte peut être utilisée pour l'accès physique à des bâtiments et l'accès à des réseaux de télécommunication de manière sécurisée. Un autre exemple d'utilisation peut être la carte bancaire utilisable pour le paiement sur un terminal de paiement ou par paiement sécurisé en ligne. Leur utilisation peut cependant être étendue à des fonctions autres sortant du registre de la sécurité et prenant appui sur les capacités de mémoire et de calcul du circuit intégré de la carte.

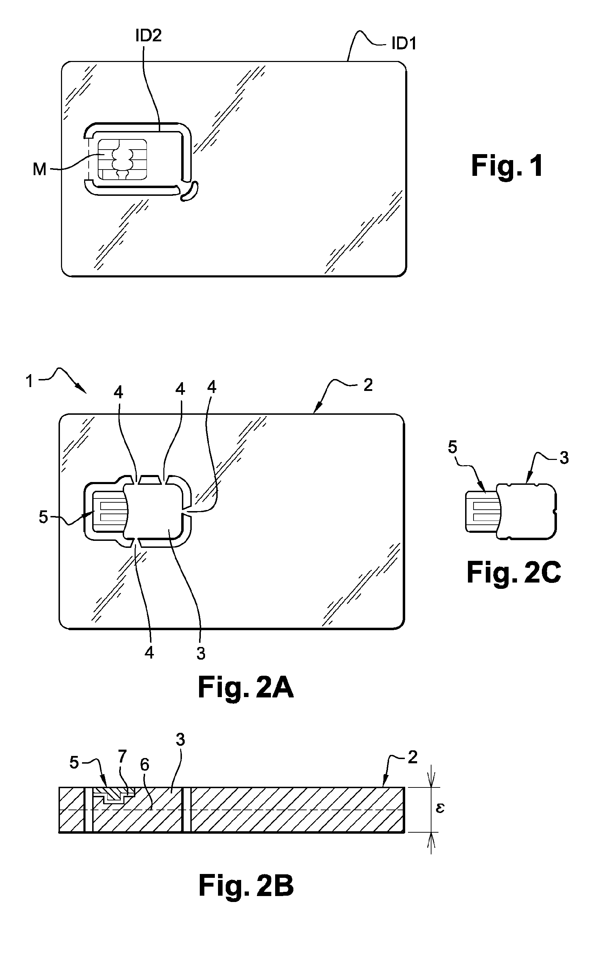

L'utilisateur peut insérer sa carte dans un terminal équipé d'un lecteur ISO 7816 ou dans un ordinateur muni d'un port USB de manière qu'une connexion électrique soit établie entre ledit terminal et les plages de contact de la carte. En pratique, ces cartes sont au format ISO ID1 (taille carte de crédit) et peuvent inclure une partie séparable au format ISO ID0 (taille mini carte pour téléphone mobile) comme montré sur la figure 1. Les plages de contact du module M de la carte sont configurée selon la norme 7816-2. En outre ce type de carte dispose d'une épaisseur de 800 µm.

De par leur constitution, les rares cartes à puce fonctionnant selon le protocole USB ne sont pas directement enfichable dans un port USB et nécessitent un connecteur intermédiaire capable de recevoir une carte au format ISO ID1 et/ou une mini carte ISO ID0. A titre d'exemple, les demandes EP-A-1 181 663 et EP-A-1 556 821 montrent des exemples de connecteur intermédiaire.

Les cartes à puces sont peu coûteuses en raison d'un nombre de composants peu élevé. Cependant cet avantage de prix diminue dès lors qu'il est nécessaire d'ajouter un connecteur intermédiaire.

Un autre avantage des cartes à puce provient de leur facteur de forme plat qui est facilement imprimable. Une clef USB ayant un boîtier moulé est plus difficilement personnalisable et le coût d'une personnalisation d'un petit nombre de clef est nettement supérieur au coût pour une carte à puce.

Le facteur de forme de la carte permet également de les distribuer par simple courrier postal ou à l'intérieur d'un magazine. Cela permet d'utiliser la carte comme support publicitaire associé à un petit contenu numérique. Le facteur de forme d'une clef USB conventionnelle ne permet pas d'avoir un tel mode de distribution. Cependant du fait du facteur de forme de la carte à puce, il n'est pas possible à un utilisateur de brancher celle-ci sur un ordinateur en l'absence d'un connecteur intermédiaire.

Pour remédier aux problèmes précités, il est proposer de réaliser une clef USB simplifiée en utilisant la technologie de fabrication d'une carte à puce. Cela revient également à réaliser une carte à puce adaptée pour être directement utilisée dans un connecteur mâle USB de type A. Les avantages de la carte à puce et de la clef USB sont alors réunis dans un seul produit.

L'invention est une carte à puce comportant un corps de carte et un module électronique. Le corps de carte inclut une partie détachable, une cavité étant réalisée sur une face dudit corps dans ladite partie détachable. Le module électronique inclut un substrat isolant, des zones de contact électrique placées sur une face dudit substrat et au moins un circuit intégré placé sur l'autre face dudit substrat. Le circuit intégré est électriquement relié aux zones de contact à travers le substrat. La cavité est pratiquée dans une zone de bordure de la partie détachable. Ladite zone est d'une largeur pouvant être introduite dans un connecteur au standard USB. Les zones de contact sont conforment à des zones de contact du standard USB. La partie détachable, une fois détachée, est une clef USB enfichable dans un connecteur femelle USB de type A.

Préférentiellement, le module peut comporter également des zones conductrices placées sur la même face du substrat isolant que le circuit intégré, chacune desdites zones conductrices étant reliée à l'une des zones de contact par l'intermédiaire d'au moins un puit conducteur traversant le substrat isolant, ledit puit étant métallisé, et chacune desdites zones conductrices étant électriquement reliée à un plot de contact du circuit intégré. La partie détachable peut être maintenue au corps de carte par au moins deux attaches. Les attaches peuvent se trouver à des emplacements éloignés du module de sorte qu'aucun emplacement ne rentre dans un connecteur USB lorsque l'on enfiche la clef USB. Les attaches peuvent être dimensionnées pour rompre afin de séparer la partie détachable par une simple pression d'un doigt.

L'invention sera mieux comprise, et d'autres particularités et avantages apparaîtront à la lecture de la description qui va suivre, la description faisant référence aux dessins annexés, parmi lesquels :
la figure 1 montre une carte à puce compatible USB, selon l'état de la technique,
les figures 2A à 2C montrent un mode de réalisation d'une clef USB selon l'invention,
les figures 3A et 3B montrent un module selon l'invention,

Le mode de réalisation de l'invention est décrit à l'aide de la figure 2 qui représente une carte à puce 1 en vue de face sur la figure 2A, en coupe transversale sur la figure 2B, et la clef USB après séparation sur la figure 2C.

La carte à puce 1 comporte un corps de carte 2 incluant une partie détachable 3 reliée audit corps 2 par l'intermédiaire d'attaches 4. Les attaches 4 sont par exemple au nombre de quatre comme montré sur la figure 2A mais deux attaches pourraient suffire. Les attaches 4 sont suffisamment fine pour être sécable par simple pression du doigt afin de permettre une séparation aisée de la partie détachable 3.

Le corps de carte 2 se présente sous la forme d'un parallélépipède rectangle dont les dimensions sont de l'ordre de 85,6 mm de longueur, 54 mm de largeur, et son épaisseur ε est comprise entre 2,055 mm et 2,415 mm, préférentiellement on choisira une valeur intermédiaire de 2,25 mm. Le corps de carte 2 est en plastique, thermoplastique ou thermodurcissable, par exemple constitué d'acrylonitrile butadiène styrène (ABS), de polychlorure de vinyle (PVC), de polyéthylène (PET) ou de poly-carbonates (PC). La découpe de séparation, entre le corps 2 et la partie détachable 3, et la formation des attaches 4 sont obtenus par emboutissage de la carte, découpage au laser, découpage au jet d'eau ou par moulage selon des procédés couramment utilisés dans la fabrication de cartes à puce. Les deux faces peuvent être imprimées avec un motif quelconque en utilisant tout procédé d'impression possible sur une carte, tel que par exemple offset, laser ou autre.

Le corps de carte 2 comporte une cavité 7 placée à une extrémité de la partie séparable 3 pour recevoir un module électronique 5. Dans l'exemple préféré le module 5 est placé au même endroit que pour une carte conforme au standard ISO 7816 afin de pouvoir utiliser la même machine de placement. Le module est collé dans la cavité par exemple avec de la colle cyanoacrylate.

La taille de la partie recevant le module ainsi que le module sont dimensionnés pour être à la taille du connecteur USB. Il est possible d'avoir un module de taille plus petite mais faire un fin rebord de plastique autour du module présente peu d'intérêt et complique la fabrication.

Une différence majeure avec une carte à puce conventionnelle est l'épaisseur du corps de carte. Cependant, la différence d'épaisseur existant entre 800 µm et 2,25 permet d'utiliser les mêmes machine avec des réglages modifiés. Dans une variante, afin d'éviter d'avoir trop d'écart de réglage, et donc plus de rapidité d'adaptation dans une chaîne de fabrication, il est possible de réaliser le corps de carte 2 en deux demi-corps identiques qui sont ensuite collés l'un contre l'autre. Le collage peut être réalisé à chaud ou à froid selon une technique connue. La ligne pointillée 6 illustre cette variante de réalisation.

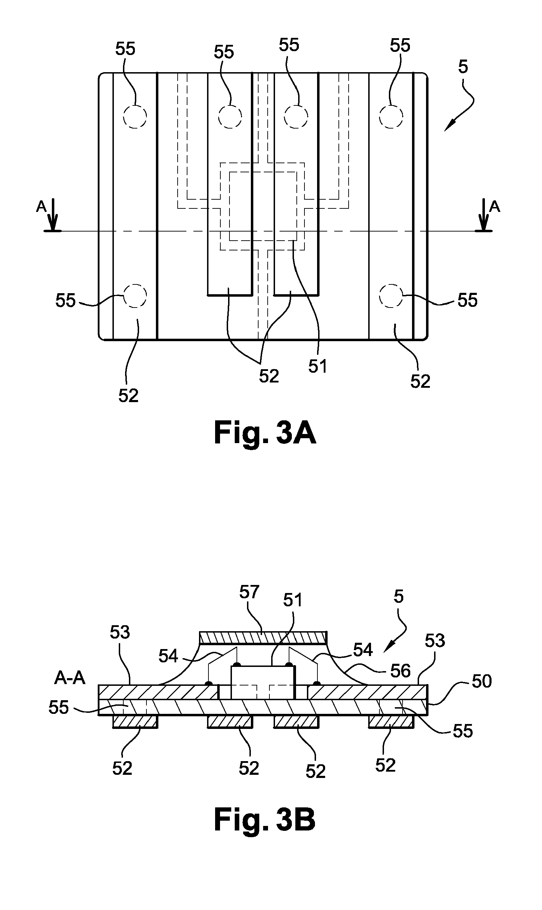

Le module électronique 5 est montré en vue de dessus sur la figure 3A et en coupe selon A-A sur la figure 3B. Le module 5 comporte un substrat isolant 50 sur une face duquel est placé un circuit intégré 51. Sur une face opposée du substrat 50, une couche métallique gravée forme des zones de contact électrique 52 dont les dimensions correspondent à celles d'une fiche mâle de type A conforme au standard USB. La couche formant les contacts électriques 52 peut être plus épaisse que pour une carte à puce conventionnelle afin d'avoir une épaisseur correspondant à ce qui est requis par la norme USB. Cette sur épaisseur devient possible car l'épaisseur du corps de carte et même d'un demi-corps de carte est plus importante que pour une carte au format ISO 7816.

Une deuxième couche métallique est placée sur la même face du substrat 50 que le circuit intégré 51 pour réaliser des zones conductrices 53 de liaison. Les zones conductrices 53, délimitées par les pointillés, s'étendent, par exemple, sur une grande partie de la surface du substrat isolant afin de donner plus de rigidité au module 5. En outre, chaque zone conductrice 53 passe au-dessus d'une zone de contact 52 et dispose d'un bord à proximité du circuit intégré 51 afin de relier électriquement un plot de contact du circuit intégré 51 à chacune des zones de contact. Un fil de liaison 54 est écrasé d'une part sur un plot de contact et d'autre part sur une zone conductrice 53 pour assurer la liaison entre le plot et ladite zone 53. Des trous métallisés ou puits conducteurs 55 traversent le substrat afin de réaliser la connexion électrique de chaque zone de contact 52 à l'une des zones conductrices 53. Un ou plusieurs trous métallisés peuvent être réalisés pour relier une zone de contact 52 à une zone conductrice 53. Le circuit intégré 51 est ensuite recouvert d'une goutte de résine et d'une pastille de protection 57, cette technique de recouvrement étant dévoilée dans la demande EP-A-0 644 507.

En variante, il est également possible de réaliser une connexion du circuit intégré 51 sur les zones conductrices avec une technologie de type Flip-Chip, également connue.

## Revendications

1. Carte à puce (1) comportant :
- un corps de carte (2) incluant une partie détachable (3), une cavité (7) étant réalisée sur une face dudit corps dans ladite partie détachable, et
- un module électronique (5) incluant un substrat isolant (50), des zones de contact électrique (52) placées sur une face dudit substrat et au moins un circuit intégré (51) placé sur l'autre face dudit substrat, le circuit intégré étant électriquement relié aux zones de contact à travers le substrat,
**caractérisé en ce que** la cavité (7) est pratiquée dans une zone de bordure de la partie détachable (3), ladite zone étant d'une largeur pouvant être introduite dans un connecteur au standard USB, **en ce que** les zones de contact (52) sont conforment à des zones de contact du standard USB, et **en ce que** la partie détachable (3), une fois détachée, est une clef USB enfichable dans un connecteur femelle USB de type A.

2. Carte à puce selon la revendication 1, dans laquelle le module (5) comporte également des zones conductrices (53) placées sur la même face du substrat isolant (50) que le circuit intégré (51), chacune desdites zones conductrices (53) étant reliée à l'une des zones de contact (52) par l'intermédiaire d'au moins un puit conducteur (55) traversant le substrat isolant (50), ledit puit (55) étant métallisé, et chacune desdites zones conductrices (53) étant électriquement reliée à un plot de contact du circuit intégré (51).

3. Carte à puce selon la revendication 1 ou 2, dans laquelle la partie détachable (3) est maintenue au corps de carte (2) par au moins deux attaches (4).

4. Carte à puce selon la revendication 3, dans laquelle les attaches (4) se trouvent à des emplacements éloignés du module de sorte qu'aucun emplacement ne rentre dans un connecteur USB lorsque l'on enfiche la clef USB.

5. Carte à puce selon la revendication 3 ou 4, dans laquelle les attaches (4) sont dimensionnées pour rompre afin de séparer la partie détachable (3) par une simple pression d'un doigt.

6. Carte à puce selon l'une des revendications précédentes, dans laquelle l'épaisseur du corps de carte (2) est comprise entre 2,055 mm et 2,415 mm.

7. Carte à puce selon l'une des revendications précédentes, dans laquelle le module (5) est positionné sur le corps de carte (2) à une position correspondant à la norme ISO 7816.
